# EUROPÄISCHE PATENTSCHRIFT

(11) **EP 3 764 545 B1**
(45) Veröffentlichungstag und Bekanntmachung des Hinweises auf die Patenterteilung: **12.04.2023**
(21) Anmeldenummer: 20180470.5
(22) Anmeldetag: 17.06.2020
(51) Int. Cl.: H03K 17/96

(54) **SENSORELEMENTEINRICHTUNG FÜR EINE BEDIENEINRICHTUNG, BEDIENEINRICHTUNG UND ELEKTROGERÄT MIT EINER SOLCHEN BEDIENEINRICHTUNG**
SENSOR ELEMENT DEVICE FOR AN OPERATING DEVICE, OPERATING DEVICE AND ELECTRICAL DEVICE WITH SUCH AN OPERATING DEVICE
DISPOSITIF D'ÉLÉMENT CAPTEUR POUR UN DISPOSITIF DE COMMANDE, DISPOSITIF DE COMMANDE ET APPAREIL ÉLECTRIQUE DOTÉ D'UN TEL DISPOSITIF DE COMMANDE

(30) Priorität: 12.07.2019 DE 102019210351
(43) Veröffentlichungstag der Anmeldung: 13.01.2021
(73) Patentinhaber: E.G.O. Elektro-Gerätebau GmbH, 75038 Oberderdingen (DE)
(72) Erfinder: SCHMID, Dennis, 76703 Kraichtal (DE); WEIN, Siegbert, 76703 Kraichtal (DE); RUPP, Michael, 75031 Eppingen (DE)
(74) Vertreter: Patentanwälte Ruff, Wilhelm, Beier, Dauster & Partner mbB

(56) Entgegenhaltungen:
- EP-A1- 2 355 356
- DE-A1-102009 036 161
- DE-A1-102010 033 390
- DE-A1-102015 214 008

## Beschreibung

### ANWENDUNGSGEBIET UND STAND DER TECHNIK

Die Erfindung betrifft eine Bedieneinrichtung mit Sensorelementeinrichtung, Leuchtanzeige und kapazitivem Berührungsschalter. Des Weiteren betrifft die Erfindung ein Elektrogerät mit einer solchen Bedieneinrichtung.

Es ist aus der EP 859 467 A1 bekannt, in einem Elektrokochfeld kapazitive Berührungsschalter einer zugehörigen Bedieneinrichtung mit kapazitiven Sensorelementen auszubilden, wobei die Kochfeldplatte als Bedienfläche dient. An die Unterseite der Kochfeldplatte an der Bedienfläche wird ein elektrisch leitfähiger elastischer Körper angedrückt. Dessen elektrisch leitfähige Oberseite bildet das kapazitive Sensorelement für den kapazitiven Berührungsschalter. Im Inneren weist der Körper einen durchgehenden Lichtleitkanal auf, in dem eine LED als Leuchtmittel angeordnet ist. Deren Licht durchstrahlt die Kochfeldplatte von unten und bewirkt die Leuchtanzeige.

Aus der DE 10 2015 214 008 A1 ist eine weitere Sensorelementeinrichtung bekannt, die in ein Kochfeld integriert werden kann und mit der sowohl eine Leuchtanzeige als auch ein kapazitiver Berührungsschalter geschaffen werden kann. Hier ist ein Lichtleitkörper mit lichtundurchlässigem Abschirmmaterial umspritzt, wobei beide elektrisch isolierend sind. Ein ausgestanztes und mehrfach umgebogenes Metallteil bildet das kapazitive Sensorelement und ist an der Oberseite und an zwei gegenüberliegenden Außenseiten bis nach unten vorgesehen. An der Unterseite stehen zwei längliche Stifte aus dem Abschirmmaterial nach unten über die Unterseite über. Damit kann die Sensorelementeinrichtung über einer LED als Leuchtmittel auf einer Leiterplatte befestigt werden.

Aus der DE 10 2009 036 161 A1 ist eine weitere Sensorelementeinrichtung für eine Bedieneinrichtung bekannt, beispielsweise an einem Elektrogerät bzw. Haushaltsgerät wie ein Kochfeld odgl.. Die Sensorelementeinrichtung weist einen kapazitiven Berührungsschalter auf und besteht aus einem lichtleitenden Kunststoffkörper, der an seiner Oberseite, möglicherweise überall an allen Außenseiten, mit einer elektrisch leitfähigen Beschichtung versehen ist. Diese Beschichtung bildet an der Oberseite das kapazitive Sensorelement. Ein stiftartiges Bauteil kann in dem Körper enthalten sein und ebenfalls elektrisch leitfähig beschichtet sein. So kann es ggf. eine elektrische Kontaktierung nach unten bilden.

Aus der EP 2 355 356 A1 ist eine weitere Bedieneinrichtung mit einer Sensorelementeinrichtung mit einem kapazitiven Berührungsschalter bekannt, die beispielsweise in ein Kochfeld odgl. eingebaut werden kann. Hier ist ebenfalls ein lichtdurchlässiger Kunststoffkörper vorgesehen, der elektrisch leitfähige ist und an seiner Oberseite das kapazitive Sensorelement bildet. Die Unterseite sitzt auf einem Bauteilträger auf und kann ggf. mit Haltebeinen in darin vorgesehene Löcher eingedrückt sein. Es kann auch eine metallische Druckfeder vorgesehen sein, die eine elektrische Kontaktierung nach unten an Kontaktflächen des Bauteilträgers übernimmt. Diese metallische Feder reicht jedoch nur bis zu einem unterhalb der halben Höhe angeordneten umlaufenden Kragen des Kunststoffkörpers. Des Weiteren drückt sie den Kunststoffkörper etwas nach oben über die Oberseite des Bauteilträgers bzw. über die Kontaktflächen, und zwar von unten an eine Bedienblende, so dass die Druckfeder selbst auf alle Fälle über die Unterseite des Kunststoffkörpers nach unten übersteht.

Aus der DE 10 2010 033 390 A1 ist eine nochmals weitere Bedieneinrichtung mit einem Sensorelement mit einem kapazitiven Sensorelement bekannt. Hier ist innerhalb eines umlaufenden Gehäuses eine metallische Druckfeder angeordnet. Sie ist mit Befestigungselementen auf bekannte Art und Weise in Ausnehmungen in Löcher in einem Bauteilträger eingesteckt und dort festgelötet.

### AUFGABE UND LÖSUNG

Der Erfindung liegt die Aufgabe zugrunde, eine eingangs genannte Bedieneinrichtung sowie ein mit einer solchen Bedieneinrichtung versehenes Elektrogerät zu schaffen, mit denen Probleme des Standes der Technik gelöst werden können und es insbesondere möglich ist, eine Sensorelementeinrichtung der Bedieneinrichtung einfach und praxistauglich auszubilden und vor allem einfach und zuverlässig montierbar auszugestalten für eine vorteilhafte Fertigung einer Bedieneinrichtung.

Gelöst wird diese Aufgabe durch eine Bedieneinrichtung mit den Merkmalen des Anspruchs 1 sowie ein Elektrogerät mit den Merkmalen des Anspruchs 12. Vorteilhafte sowie bevorzugte Ausgestaltungen der Erfindung sind Gegenstand der weiteren Ansprüche und werden im Folgenden näher erläutert. Dabei werden manche der Merkmale nur für die Bedieneinrichtung oder nur für das Elektrogerät beschrieben. Sie sollen jedoch unabhängig davon sowohl für eine Bedieneinrichtung als auch für ein Elektrogerät selbständig und unabhängig voneinander gelten können. Der Wortlaut der Ansprüche wird durch ausdrückliche Bezugnahme zum Inhalt der Beschreibung gemacht.

Es ist vorgesehen, dass die Sensorelementeinrichtung mindestens ein Sensorelement aufweist, um einen kapazitiven Berührungsschalter zu bilden, der dann an einer mit der Sensorelementeinrichtung versehenen Bedieneinrichtung vorhanden ist. Des Weiteren weist die Sensorelementeinrichtung einen Lichtleiter auf, mit dem die Leuchtanzeige gebildet wird. Der Lichtleiter besteht aus lichtdurchlässigem Material, entweder transparent oder transluzent bzw. opak für eine gleichmäßigere Lichterscheinung. Der Lichtleiter weist einen Einstrahlbereich für Licht und einen Ausstrahlbereich für Licht auf. Des Weiteren weist die Sensorelementeinrichtung Abschirmmaterial auf, das den Lichtleiter umgibt und dabei im Wesentlichen nur den Einstrahlbereich und den Ausstrahlbereich freilässt. Das Abschirmmaterial ist derart ausgebildet oder ausgewählt, dass es lichtundurchlässig ist bzw. kein Licht durchlässt, entweder weil es völlig lichtundurchlässiges Material ist oder aber in Verbindung mit dem Lichtleiter, insbesondere in den Verbindungsflächen, kein Licht durchlässt bzw. sämtliches Licht wieder in den Lichtleiter zurückreflektiert. Die Sensorelementeinrichtung weist eine Unterseite und eine Oberseite auf, insbesondere dann, wenn sie die Form eines Quaders aufweist oder als Quader bzw. blockartig ausgebildet ist. In diesem Fall sind die Unterseite und die Oberseite eben entsprechend gegenüberliegend an der Quaderform oder der Blockform vorgesehen. Der Ausstrahlbereich des Lichtleiters ist vorteilhaft nahe der Oberseite oder an der Oberseite vorgesehen. Der Einstrahlbereich ist vorteilhaft oberhalb der Unterseite vorgesehen bzw. ist hier eine Ausnehmung unten an der Sensorelementeinrichtung vorgesehen, in der ein Leuchtmittel, beispielsweise eine LED, Platz finden kann, so dass zumindest ein Mindestabstand zu dem Einstrahlbereich darüber vorgesehen ist.

Des Weiteren weist die Sensorelementeinrichtung eben mindestens ein metallisches Sensorelement als Bauteil auf, das aus mindestens einem Metallteil besteht. Vorteilhaft weist die Sensorelementeinrichtung ein oder zwei Metallteile auf, die dann gemeinsam das kapazitive Sensorelement für einen einzigen Berührungsschalter der Sensorelementeinrichtung bilden. Dazu können sie vorteilhaft elektrisch verbunden sein. Das Sensorelement verläuft von der Unterseite bis zu der Oberseite, vorteilhaft bildet es die Ebenen von Unterseite und Oberseite oder verläuft in diesen Ebenen.

Die Sensorelementeinrichtung bildet eine integrierte Baueinheit mit dem Lichtleiter, dem Abschirmmaterial und dem Sensorelement. Vorteilhaft kann es als Spritzgussteil hergestellt sein, was eine kostengünstige und präzise Herstellung ermöglicht.

Dabei ragt das Sensorelement bzw. das genannte Metallteil bis zu einer Ebene der Unterseite der Sensorelementeinrichtung, so dass es diese Ebene zumindest teilweise definiert bzw. darin verläuft. An der Oberseite kann dies auch so vorgesehen sein, muss aber nicht.

Erfindungsgemäß ragt kein Teil der Sensorelementeinrichtung über die Unterseite der Sensorelementeinrichtung oder über das Sensorelement selbst nach unten über bzw. steht nicht nach unten über. Somit ist gewährleistet, dass die Sensorelementeinrichtung bei Platzieren auf eine ebene Fläche mit dem Sensorelement diese ebene Fläche berührt oder maximal 1 mm übersteht. Dadurch ist es mit der Erfindung möglich, die Sensorelementeinrichtung gut, einfach und dauerhaft zuverlässig elektrisch anzuschließen. Dieser elektrische Anschluss kann gleichzeitig eine mechanische Befestigung sein. Vor allem kann dieser elektrische Anschluss bevorzugt als SMD-Anschluss ausgebildet sein, wodurch er sehr vorteilhaft realisiert werden kann. Dabei kann es auch erreicht werden, dass die Sensorelementeinrichtung mit einem SMD-Bestückungsautomaten auf an sich bekannte Art und Weise auf einem Bauteilträger der Bedieneinrichtung platziert wird, vorteilhaft mehrere Sensorelementeinrichtungen mit gleicher oder identischer Bauform.

In vorteilhafter Ausgestaltung der Erfindung grenzt das Sensorelement nicht an den Lichtleiter an bzw. an dessen lichtdurchlässiges Material. Es wird als vorteilhaft angesehen, wenn das Sensorelement getrennt von dem Lichtleiter verläuft, also mit Abstand von mindestens 1 mm, damit die jeweilige Ausgestaltung möglichst optimiert für ihre Funktion sein kann. Dies gilt sowohl für den Lichtleiter bzw. seine mit lichtdurchlässigem Material gebildete Form als auch für das Sensorelement. Für das Abschirmmaterial ist dies erheblich einfacher, da es eben nur die Aufgabe hat, lichtundurchlässig zu sein bzw. kein Licht aus dem Lichtleiter ungewünscht austreten zu lassen. Das Abschirmmaterial verläuft also vorteilhaft zumindest teilweise zwischen Lichtleiter und Sensorelement bzw. zwischen Lichtleiter und Sensorelement ist immer Abschirmmaterial.

In weiterer Ausgestaltung der Erfindung ist es möglich, dass ein Sensorelement bzw. das einzige Sensorelement an einer Seite der Sensorelementeinrichtung verläuft. Insbesondere kann es an einer Außenseite verlaufen, so dass diese Seite tatsächlich quasi an die Luft angrenzt oder nach außen weist.

In alternativer Ausgestaltung der Erfindung, insbesondere wenn mehrere Sensorelemente an einer einzigen Sensorelementeinrichtung vorgesehen sind, kann es bevorzugt sein, dass mindestens ein Sensorelement an mindestens zwei Seiten der Sensorelementeinrichtung verläuft. Ist nur ein einziges Sensorelement an der Sensorelementeinrichtung vorgesehen, so sind dies vorteilhaft zwei aneinander angrenzende Seiten, drei aneinander angrenzende Seiten oder möglicherweise sogar alle aneinander angrenzenden Seiten. Alternativ können mindestens zwei getrennte und separate Sensorelemente an einer einzigen Sensorelementeinrichtung vorgesehen sein, die dann vorteilhaft an gegenüberliegenden Seiten vorgesehen sind. Dies gilt jeweils insbesondere für eine Quaderform oder Blockform der Sensorelementeinrichtung. Sind zwei getrennte und separate Sensorelemente vorgesehen, so ist es aus Fertigungsgründen und Lagerhaltungsgründen bevorzugt, wenn sie spiegelbildlich gleich oder sogar identisch sind. Auch hier kann vorzugsweise vorgesehen sein, dass sämtliche Sensorelemente an einer Sensorelementeinrichtung elektrisch miteinander verschaltet sind bzw. durch Verbinden wie ein einziges kapazitives Sensorelement wirken, um einen kapazitiven Berührungsschalter zu bilden.

Solche angeformten Sensorelemente bzw. die sie bildenden Metallteile sind vorteilhaft mehrfach umgebogen bzw. abgewinkelt. So können sie an die Form der Sensorelementeinrichtung angepasst werden, insbesondere auch für eine elektrische Kontaktierung ausgebildet sein.

In vorteilhafter Ausgestaltung der Erfindung ist die Sensorelementeinrichtung im Spritzgussverfahren hergestellt, insbesondere in einem mehrstufigen Mehrkomponentenspritzgussverfahren. Dabei werden vorteilhaft Lichtleiter und Abschirmmaterial aneinander angespritzt, wobei die Reihenfolge variabel ist. Anschließend kann das mindestens eine metallische Sensorelement an diesem Bauteil befestigt werden, um die Sensorelementeinrichtung zu bilden. Alternativ kann auch das mindestens eine Sensorelement mittels des Abschirmmaterials verspritzt werden, insbesondere auch zusammen mit dem Lichtleiter. Dabei kann das mindestens eine Sensorelement angespritzt oder zumindest teilweise umspritzt sein, so dass es stabil und dauerhaft mit der Sensorelementeinrichtung verbunden ist. Insbesondere ist das Sensorelement aber an der Unterseite der Sensorelementeinrichtung, vorteilhaft auch mit einer Höhe von bis zu 2 mm oder bis zu 3 mm über der Unterseite, nicht umspritzt bzw. liegt frei. Dies kann für eine vorgenannte elektrische Verbindung und mechanische Verbindung verwendet werden, vorzugsweise mittels SMD-Löten. Auch an der Oberseite sollte das Sensorelement freiliegen, um direkt an eine Unterseite einer Bedienfläche einer erfindungsgemäßen Bedieneinrichtung angedrückt zu werden.

Alternativ kann hier auch eine dünne Abdeckung darüber vorgesehen sein, beispielsweise aus dem Abschirmmaterial, alternativ aus elastischem Silikon odgl..

Ein Umbiegen des Sensorelements im Bereich der Oberseite und/oder im Bereich der Unterseite kann so sein, dass es hin zu einem Mittelbereich dieser Seite umgebogen ist, also nicht weg von der Sensorelementeinrichtung bzw. dem Lichtleiter, der vorteilhaft in etwa durch deren Mitte verläuft, sondern dazu hin. Eine Umbiegung hier kann in etwa rechtwinklig erfolgen, so dass ein umgebogener Abschnitt des Sensorelements in etwa parallel und vorteilhaft entsprechend der Oberseite oder der Unterseite oder jeweils ihrer Ebene verläuft. Auch bei diesen umgebogenen Abschnitten eines Sensorelements kann vorgesehen sein, dass noch ein Abstand zu dem Lichtleiter gewahrt bleibt.

Zusätzlich oder alternativ zu einer vorgenannten Abdeckung oberhalb der Sensorelementeinrichtung, die beispielsweise aus elastischem Silikon bestehen kann, kann vorgesehen sein, dass auf der Oberseite der gesamten Sensorelementeinrichtung oder auf der Oberseite nur des Lichtleiters, vorteilhaft also an dem Ausstrahlbereich, eine lichtundurchlässige Abdeckung oder Beschichtung vorgesehen ist. Diese ist vorteilhaft so ausgebildet, dass sie in einem gewünschten Bereich entfernt werden kann, um ein durchleuchtetes Symbol oder Zeichen anzeigen zu können, wie dies an sich aus dem Stand der Technik von derartigen Sensorelementeinrichtungen bekannt ist, siehe beispielsweise die oben genannte DE 10 2015 214 008 A1. Eine solche lichtundurchlässige Abdeckung oder Beschichtung kann relativ dünn ausgebildet sein, sie muss nur eben lichtundurchlässig sein, insbesondere für Lichtstärken, wie sie üblicherweise bei LED in Bedieneinrichtungen für Elektrogeräte verwendet werden. Eine besonders vorteilhafte Möglichkeit ist eine lichtundurchlässige Abdeckung oder Beschichtung, die mit einem Laser entfernt werden kann, um so einen Ausschnitt zur Durchstrahlung mit Licht aus dem Ausstrahlbereich herauszuarbeiten. So kann nicht nur eine indifferente oder allgemeine Leuchtanzeige geschaffen werden, sondern eine in Symbolform.

In vorteilhafter Ausgestaltung der Erfindung ist vorgesehen, dass genau eine Sensorelementeinrichtung genau einen kapazitiven Berührungsschalter bildet. In ähnlicher Form bildet sie auch genau eine einzige Leuchtanzeige.

Ein Sensorelement kann aus einem relativ dünnen Metall bestehen, beispielsweise einem Kupferblech mit einer Stärke von 0,01 mm bis 0,5 mm. An der Oberseite kann es umgebogen sein mit einer Länge von 0,5 mm bis 2 mm, so dass sich eine gewisse Fläche ergibt, wenn auch geringfügig, welche für die zuverlässige Funktion als kapazitiver Berührungsschalter üblicherweise von großem Vorteil ist.

Eine erfindungsgemäße Bedieneinrichtung weist einen Bauteilträger auf, insbesondere eine Leiterplatte, auf dem mindestens eine Sensorelementeinrichtung angeordnet ist und elektrisch angeschlossen ist. Vorteilhaft sind auf diesem Bauteilträger sämtliche Sensorelementeinrichtungen der gesamten Bedieneinrichtung angeordnet und elektrisch angeschlossen. Hierfür ist auf der Oberseite mindestens ein Kontaktfeld vorgesehen, vorteilhaft ein Kontaktfeld pro einzelnem Sensorelementteil der Sensorelementeinrichtung. Darauf kann dann, vorteilhaft mit dem vorgenannten SMD-Löten, alternativ mit einem Leitkleber, die Sensorelementeinrichtung elektrisch angeschlossen und befestigt werden.

Neben einem erfindungsgemäßen Elektrogerät, das als Elektrokochfeld ausgebildet sein kann, wobei eine Kochfeldplatte mit einem Teil die Bedienfläche bildet, können auch andere Elektrogeräte, insbesondere Elektrokochgeräte, mit einer solchen erfindungsgemäßen Bedieneinrichtung versehen sein. Dies können Backöfen, Mikrowellen oder Dampfgarer sein, ebenso auch andere Elektrogeräte wie Geschirrspüler oder Waschmaschinen.

### KURZBESCHREIBUNG DER ZEICHNUNGEN

Ausführungsbeispiele der Erfindung sind in den Zeichnungen schematisch dargestellt und werden im Folgenden näher erläutert. In den Zeichnungen zeigen:
- Fig. 1: eine Schnittdarstellung durch eine Sensorelementeinrichtung in einer ersten Ausgestaltung der Erfindung,
- Fig. 2: eine Draufsicht auf die Sensorelementeinrichtung aus Fig. 1,
- Fig. 3: eine Seitenansicht einer erfindungsgemäßen Bedieneinrichtung mit einer vorgenannten Sensorelementeinrichtung, die in ein erfindungsgemäßes Kochfeld integriert ist und
- Fig. 4: eine Abwandlung einer Bedieneinrichtung ähnlich derjenigen aus Fig. 1 in Schnittdarstellung.

### DETAILLIERTE BESCHREIBUNG DER AUSFÜHRUNGSBEISPIELE

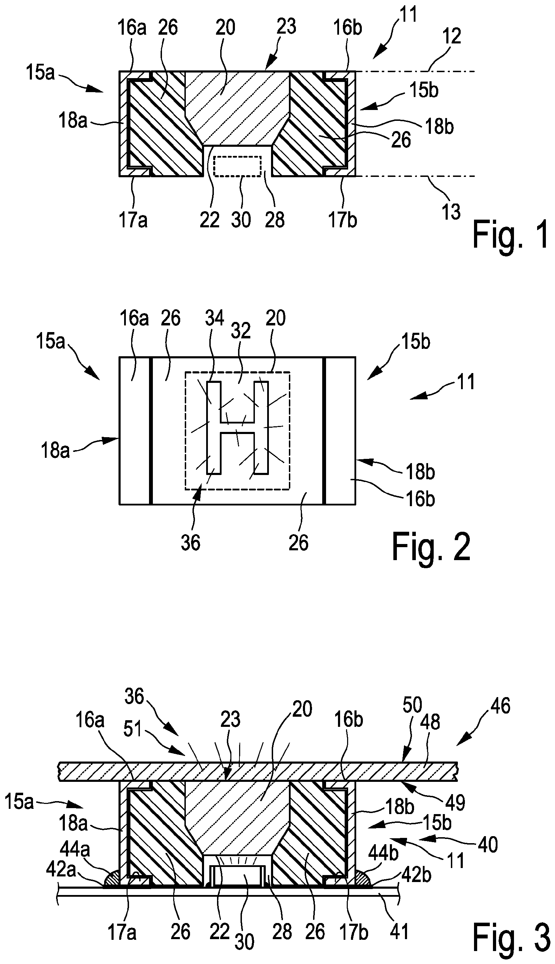

In der Fig. 1 ist eine erfindungsgemäße Sensorelementeinrichtung 11 in Seitenansicht bzw. im seitlichen Schnitt gezeigt. Die Sensorelementeinrichtung 11 weist eine Oberseite 12 und eine Unterseite 13 auf, die hier in Verlängerung jeweils strichpunktiert dargestellt sind. Oberseite 12 und Unterseite 13 verlaufen im Wesentlichen in einer Ebene.

Die Sensorelementeinrichtung 11 ist als integrierte Baueinheit hergestellt und weist links ein Sensorelement 15a und rechts ein Sensorelement 15b auf. Das Sensorelement 15a weist einen oberen Winkelabschnitt 16a und einen unteren Winkelabschnitt 17a auf. Dazwischen verläuft ein Seitenteil 18a. Das rechte Sensorelement 15b ist identisch ausgebildet mit einem oberen Winkelabschnitt 16b, einem unteren Winkelabschnitt 17b und einem Seitenteil 18b dazwischen. Das rechte Sensorelement 15b ist spiegelbildlich zu dem linken Sensorelement 15a angeordnet. Die Winkelabschnitte 16 und 17 sind jeweils in etwa rechtwinklig zu den Seitenteilen 18 und können in der Praxis auch mehr gerundet ausgebildet sein. Wie zu ersehen ist, verläuft die Oberseite bzw. Außenseite der oberen Winkelabschnitte 16 genau in der Ebene der Oberseite 12. In ähnlicher Form verläuft die Unterseite bzw. Außenseite der unteren Winkelabschnitte 17 genau in der Ebene der Unterseite 13. Während die Winkelabschnitte 16 und 17 sozusagen flächig ohne Unterbrechung oder Durchbrechung ausgebildet sind, kann dies für die Seitenteile 18 anders sein, insbesondere um einen Spritzvorgang bzw. ein Einspritzen zu unterstützen. Dies wird nachfolgend noch näher ausgeführt.

Im Mittelbereich der Sensorelementeinrichtung 11 ist ein Lichtleiter 20 vorgesehen aus lichtdurchlässigem Material, das vorteilhaft entweder völlig transparent oder leicht opak sein kann. Durch eine solche opake Ausgestaltung kann eine Durchleuchtung und somit auch eine dadurch hervorgerufene Leuchtanzeige etwas vergleichmäßigt werden, wenngleich die Leuchtstärke etwas reduziert wird. Der Lichtleiter 20 weist unten einen Einstrahlbereich 22 und oben einen Ausstrahlbereich 23 auf. Er ist von lichtundurchlässigem Abschirmmaterial 26 umgeben, was vor allem die Draufsicht auf die Sensorelementeinrichtung 11 in Fig. 2 zeigt. Dieses umgibt den Lichtleiter 20 zu allen vier Seiten hin vollständig, möglicherweise reicht es jeweils bis zur Ebene der Unterseite 13. Unterhalb des Lichtleiters 20 bzw. des Einstrahlbereichs 22 ist dadurch eine Ausnehmung 28 gebildet, in der eine gestrichelt angedeutete LED 30 angeordnet werden kann für die Leuchtanzeige.

Das Abschirmmaterial 26 und der Lichtleiter 20 sind vorteilhaft in einem Spritzgussverfahren gemeinsam hergestellt. Vorteilhaft kann dabei der Lichtleiter 20 mit dem Abschirmmaterial 26 umspritzt werden, wobei der Lichtleiter 20 davor schon als fertiges Teil vorliegt. Anschließend können die Sensorelemente 15a und 15b seitlich angebracht bzw. befestigt werden, beispielsweise gerastet, geklemmt oder geklipst. In einer weiteren Ausgestaltung ist es möglich, dass der Lichtleiter 20 und die Sensorelemente 15a und 15b in eine Spritzgussform eingebracht werden und dann mit dem Abschirmmaterial 26 zu einer Baueinheit verspritzt werden. Das Abschirmmaterial 26 sowie auch der Lichtleiter 20 sind vorteilhaft elektrisch isolierend.

Aus der Fig. 1 ist zu ersehen, dass der Ausstrahlbereich 23 und die Oberseite des Abschirmmaterials 26 ebenfalls nicht über die Ebene der Oberseite 12 überstehen bzw. in dieser verlaufen. In ähnlicher Form verläuft das Abschirmmaterial 26 an seiner Unterseite in der Ebene der Unterseite 13 der gesamten Sensorelementeinrichtung 11. Aufgrund der Ausnehmung 28 liegt der Einstrahlbereich 22 des Lichtleiters 20 hier signifikant höher.

Aus der Draufsicht auf die Sensorelementeinrichtung 11 aus Fig. 2 ist zu ersehen, wie die Sensorelemente 15a und 15b mit den oberen Winkelabschnitten 16a und 16b eine gewisse Fläche bilden bzw. zwei separate Flächen, die elektrisch in einer Bedieneinrichtung zusammengeschaltet sind. Selbst wenn deren Fläche gering scheinen mag, so reicht sie doch aus, um eine ausreichende Fläche für ein davon gebildetes kapazitives Sensorelement für einen kapazitiven Berührungsschalter zu bilden. Dies ist dem Fachmann aber an sich bekannt. Da eine vorteilhafte Länge einer Sensorelementeinrichtung zwischen 5 mm und 15 mm und eine Breite zwischen 3 mm und 9 mm liegen, werden in der Regel bei Auflegen eines Fingers auf eine Berührfläche darüber beide oberen Winkelabschnitte 16a und 16b und somit auch beide Sensorelemente überdeckt.

In der Draufsicht ist der Lichtleiter 20 strichliert dargestellt. Er wird nach oben von einer dünnen, aber lichtundurchlässigen Beschichtung 32 bedeckt. Diese kann auch die gesamte Oberseite des Abschirmmaterials 26 überdecken, möglicherweise auch eine Oberseite der oberen Winkelabschnitte 16. Diese Beschichtung 32 ist so ausgebildet, dass mit einem Laser auf an sich bekannte Art und Weise ein Symbolausschnitt 34, hier als "H", beispielsweise für eine Heiß-Anzeige, herausgearbeitet werden kann. In diesem Symbolausschnitt 34 ist also keine Beschichtung vorgesehen, so dass hier Licht am Ausstrahlbereich 23 aus dem Lichtleiter 20 austreten kann. So wird eine Leuchtanzeige 36 mit einem leuchtenden bzw. beleuchteten "H" geschaffen.

Es ist auch leicht vorstellbar, dass nur eines der jeweils zwei dargestellten Sensorelemente vorgesehen wäre, also nur an einer Seite. Ebenso könnte ein Sensorelement auch noch sozusagen einmal oder zweimal um die Ecke gebogen sein an einer Außenseite der Sensorelementeinrichtung 11, die in die Zeichenebene hineinzeigt oder aus der Zeichenebene herauszeigt.

Aus den Fig. 1 und 2 ist auch ersichtlich, dass die gesamte Sensorelementeinrichtung 11 Quaderform bzw. Blockform aufweist.

Eine Beschichtung 32 an der Oberseite 12 der Sensorelementeinrichtung 11 sollte vorteilhaft nicht zu dick sein. Sie kann entweder mit ihrer Dicke so berechnet werden, dass sie auf der Oberseite des Lichtleiters 20 und des Abschirmmaterials 26 genauso hoch ist wie die Oberseiten der oberen Winkelabschnitte 16. Alternativ kann sie auch auf diese überlappen bzw. auf ihnen verlaufen, um als eine Art Kratzschutz zu dienen, damit die metallischen Sensorelemente 15 nicht an der Unterseite einer Kochfeldplatte 48, die üblicherweise aus Glaskeramik besteht, anliegen und diese zerkratzen.

Die Fig. 3 zeigt, wie die Sensorelementeinrichtung 11 aus den Fig. 1 und 2 in eine Bedieneinrichtung 40 integriert ist. Die Bedieneinrichtung 40 weist eine Leiterplatte 41 mit zwei beabstandeten Kontaktfeldern 42a und 42b auf. Leiterbahnen für einen elektrischen Anschluss sind nicht dargestellt. Auf diesen Kontaktfeldern 42 liegt eine Sensorelementeinrichtung 11 auf und ist mit den unteren Winkelabschnitten 17a und 17b sowie auch mit einem geringen Teil der unteren Bereiche der Seitenteile 18a und 18b mittels Lötzinn 44a und 44b verlötet. Dies findet vorteilhaft in einem SMD-Prozess statt derart, dass die Sensorelementeinrichtung 11 von einem SMD-Bestückungsautomaten auf der vorbereiteten Leiterplatte 41 platziert wird. Auf den Kontaktfeldern 42a und 42b befinden sich dann schon geringe Mengen an Lötzinn 44a und 44b. Des Weiteren kann ein üblicher SMD-Klebepunkt zum mechanischen Fixieren die Sensorelementeinrichtung 11 nach ihrem Aufsetzen bzw. Bestücken mechanisch haltern, bis sie mittels des Lötzinns 44a und 44b nicht nur elektrisch verbunden, sondern auch mechanisch dauerhaft befestigt ist. In ähnlicher Form ist die LED 30 als SMD-Bauteil auf nicht dargestellten Kontaktfeldern auf der Leiterplatte 41 befestigt.

Die Bedieneinrichtung 40 weist nach oben hin eine Bedienfläche auf. Hierfür dient eine Kochfeldplatte 48 eines Kochfelds 46, in welches die Bedieneinrichtung 40 integriert ist. Die Kochfeldplatte 48 weist eine Unterseite 49 und eine Oberseite 50 auf. Oberhalb der Sensorelementeinrichtung 11 ist an der Oberseite 50 eine Berührfläche 51 ausgebildet, welche sozusagen die Stelle ist, an der der kapazitive Berührungsschalter durch Auflegen eines Fingers einer Bedienperson betätigt werden kann. Die Kochfeldplatte 48 ist auch lichtdurchlässig, so dass Licht von der LED 30 hindurchstrahlen kann und, eventuell vorteilhaft mit einer Symbolform ähnlich Fig. 2, eine bestimmte Leuchtanzeige 36 bildet. Dies ist an sich von ähnlichen Sensorelementeinrichtungen auch bekannt.

Vorteilhaft weist das Kochfeld 46 zwar nur eine einzige Bedieneinrichtung 40 auf, diese auf ihrer Leiterplatte 41 aber mehrere oder eine Vielzahl von Sensorelementeinrichtungen 11, beispielsweise zwischen fünf und fünfzig. Die Sensorelementeinrichtungen 11 sind sämtlich mit ihrer Oberseite an die Unterseite 49 der Kochfeldplatte 48 angelegt, so dass eine exakte und gleichbleibende Zuordnung der oberen Winkelabschnitte 16 zu der Kochfeldplatte 48 und der Oberseite 50 gegeben ist.

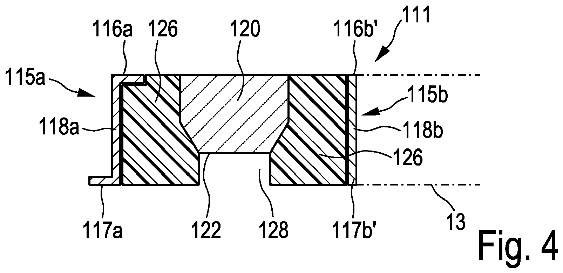

In der Fig. 4 ist eine Abwandlung einer weiteren erfindungsgemäßen Sensorelementeinrichtung 111 dargestellt. Sie weist entsprechend Fig. 1 einen Lichtleiter 120 und um diesen herum Abschirmmaterial 126 auf. Unten ist eine Ausnehmung 128 für eine LED vorgesehen. Links ist eine erste Ausgestaltung eines alternativen Sensorelements 115a vorgesehen mit einem oberen abgebogenen Winkelabschnitt 116a und einem Seitenteil 118a, die der Fig. 1 entsprechen. Der untere Winkelabschnitt 117a ist aber nicht nach innen sondern nach außen abgebogen. Dies kann möglicherweise eine Befestigung bzw. elektrische Kontaktierung erleichtern. Anhand dessen ist auch leicht vorstellbar, dass, unabhängig von der Ausgestaltung des unteren Winkelabschnitts 117a, der obere Winkelabschnitt 116a in ähnlicher Weise nach außen, also weg von der Sensorelementeinrichtung 111, abgebogen sein könnte.

Das rechte Sensorelement 115b ist nochmals anders ausgestaltet. Hier ist eigentlich nur ein Seitenteil 118b vorgesehen, weder oben noch unten sind Winkelabschnitte vorgesehen. Das Sensorelement bzw. Seitenteil kann also allgemein flach sein, insbesondere ohne abstehende oder abgebogene Abschnitte bzw. Teile. Nach unten ist eine Unterkante 117b` des Seitenteils 118b vorgesehen, was für einen elektrischen Kontakt mittels SMD-Löten ausreicht. Dieses kann seitlich heranlappen an die Außenseite des Seitenteils 118b im unteren Bereich. Nach oben ist ebenfalls nur eine Seitenkante 116b` des Seitenteils 118b vorgesehen, so dass hier eine Fläche für ein kapazitives Sensorelement im Wesentlichen nur von der Fläche dieser Seitenkante gebildet wird bzw. daraus besteht. Je nach Materialdicke des Seitenteils 118b ergibt sich dadurch eine sehr geringe Fläche für das kapazitive Sensorelement. Daraus resultiert, dass der damit hergestellte kapazitive Berührungsschalter möglicherweise nicht sehr empfindlich bzw. eher störanfällig ist. Dies kann aber durch entsprechend geeignete Beschaltung und Ansteuerung und Auswertung gut ausgeglichen werden. Derartige Sensorelemente 115b können natürlich sehr leicht hergestellt werden, da sie keine Abwinkelung aufweisen, und sie können auch relativ leicht in einem Spritzgussverfahren für die Herstellung der Sensorelementeinrichtung 111 verwendet werden.

Es ist jeweils zu erkennen aus den Fig. 1 und 4, dass kein Teil der Sensorelementeinrichtung über die Ebene der Oberseite oder über die Ebene der Unterseite heraussteht. Eine Befestigung der Sensorelementeinrichtung auf einem Bauteilträger bzw. der Leiterplatte 41 ist aber mittels SMD-Löten gut und zuverlässig möglich.

## Patentansprüche

1. Bedieneinrichtung (40) mit einer Leuchtanzeige (36) und mit einem kapazitiven Berührungsschalter und einer Sensorelementeinrichtung (11, 111) für den kapazitiven Berührungsschalter,
wobei die Sensorelementeinrichtung (11, 111) aufweist:
- ein Sensorelement (15, 115) für den kapazitiven Berührungsschalter der Bedieneinrichtung (40),
- einen Lichtleiter (20, 120) für die Leuchtanzeige (36), der aus lichtdurchlässigem Material besteht, wobei der Lichtleiter (20, 120) einen Einstrahlbereich (22, 122) für Licht aufweist und einen Ausstrahlbereich (23) für Licht aufweist,
- Abschirmmaterial (26, 126), das den Lichtleiter (20, 120) bis auf den Einstrahlbereich (22, 122) und den Ausstrahlbereich (23) umgibt, wobei das Abschirmmaterial (26, 126) lichtundurchlässig ist in Verbindung mit dem Lichtleiter (20, 120),
- mindestens ein metallisches Sensorelement (15, 115), das aus mindestens einem Metallteil besteht,
wobei:
- die Sensorelementeinrichtung (11, 111) eine Unterseite (13) und eine Oberseite (12) aufweist,
- das Sensorelement (15, 115) von der Unterseite (13) der Sensorelementeinrichtung (11, 111) bis zu der Oberseite (12) der Sensorelementeinrichtung (11, 111) verläuft,
- die Sensorelementeinrichtung (11, 111) eine integrierte Baueinheit bildet mit Lichtleiter (20, 120), Abschirmmaterial (26, 126) und Sensorelement (15, 115), insbesondere als Spritzgussteil,
- das Sensorelement (15, 115) bis zu einer Ebene der Unterseite (13) der Sensorelementeinrichtung (11, 111) ragt und die Ebene der Unterseite (13) zumindest teilweise definiert,
- kein Teil der Sensorelementeinrichtung (11, 111) über die Unterseite (13) der Sensorelementeinrichtung (11, 111) oder über das Sensorelement (15, 115) nach unten übersteht,
- die Bedieneinrichtung (40) eine Bedienfläche (48) aufweist, unter der die Sensorelementeinrichtung (11, 111) angeordnet ist,
- das kapazitive Sensorelement (15, 115) oder einer der Abschnitte des kapazitiven Sensorelements (15, 115) mit seiner Oberseite (16, 116) an eine Unterseite (49) der Bedienfläche (48) angelegt ist,
- die Bedieneinrichtung (40) einen Bauteilträger (41) aufweist, auf dem die Sensorelementeinrichtung (11, 111) angeordnet ist und elektrisch angeschlossen ist,
- der Bauteilträger (41) auf seiner Oberseite mindestens ein Kontaktfeld (42) aufweist, auf dem das kapazitive Sensorelement (15, 115) anliegt und mechanisch sowie elektrisch verbunden ist.

2. Bedieneinrichtung nach Anspruch 1, **dadurch gekennzeichnet, dass** das kapazitive Sensorelement (15, 115) auf dem Kontaktfeld (42) angelötet (44) ist oder mit elektrischem Leitkleber festgeklebt ist.

3. Bedieneinrichtung nach einem der vorhergehenden Ansprüche, **dadurch gekennzeichnet, dass** das Sensorelement (15, 115) nicht an den Lichtleiter (20, 120) angrenzt bzw. getrennt von dem Lichtleiter (20, 120) verläuft.

4. Bedieneinrichtung nach einem der vorhergehenden Ansprüche, **dadurch gekennzeichnet, dass** das das Sensorelement (15, 115) an einer Seite der Sensorelementeinrichtung (11, 111) verläuft.

5. Bedieneinrichtung nach einem der Ansprüche 1 bis 3, **dadurch gekennzeichnet, dass** das Sensorelement (15, 115) mindestens an zwei Seiten der Sensorelementeinrichtung (11, 111) verläuft, vorzugsweise an aneinander angrenzenden Seiten oder an gegenüberliegenden Seiten, wobei insbesondere im ersten Fall ein einziges Sensorelement (15, 115) vorgesehen ist, das abgebogen bzw. abgewinkelt ist, und im zweiten Fall zwei getrennte und separate Sensorelemente (15, 115) vorgesehen sind, vorzugsweise identische oder spiegelbildlich gleiche Sensorelemente (15, 115).

6. Bedieneinrichtung nach einem der vorhergehenden Ansprüche, **dadurch gekennzeichnet, dass** die Sensorelementeinrichtung (11, 111) im Spritzgussverfahren hergestellt ist, insbesondere im Mehrkomponentenspritzgussverfahren, wobei vorzugsweise das mindestens eine Sensorelement (15, 115) angespritzt oder eingespritzt bzw. zumindest teilweise umspritzt ist.

7. Bedieneinrichtung nach einem der vorhergehenden Ansprüche, **dadurch gekennzeichnet, dass** das Sensorelement (15, 115) an einer Außenseite vorgesehen ist, wobei es vorzugsweise freiliegend ist an der Außenseite.

8. Bedieneinrichtung nach einem der vorhergehenden Ansprüche, **dadurch gekennzeichnet, dass** das Sensorelement (15) im Bereich der Unterseite (13) der Sensorelementeinrichtung (11) umgebogen ist an die Unterseite (13), insbesondere mit einem Winkelabschnitt (17) umgebogen ist, der vorzugsweise mit einer Außenseite an der Sensorelementeinrichtung (11) bzw. an dem Abschirmmaterial (26) anliegt und mit einer anderen Außenseite in der Ebene der Unterseite (13) der Sensorelementeinrichtung (11) verläuft bzw. einen Teil dieser Unterseite (13) bildet und die Ebene der Unterseite (13) zumindest teilweise definiert.

9. Bedieneinrichtung nach einem der vorhergehenden Ansprüche, **dadurch gekennzeichnet, dass** das Sensorelement (15, 115) in einem oberen Bereich, der vorzugsweise in einer Fläche der Oberseite (12) der Sensorelementeinrichtung (11, 111) verläuft, umgebogen ist hin zu einem Mittelbereich dieser Oberseite (12), vorzugsweise in etwa rechtwinklig umgebogen ist, insbesondere einen Abstand zu dem Lichtleiter (20, 120) aufweist.

10. Bedieneinrichtung nach einem der vorhergehenden Ansprüche, **dadurch gekennzeichnet, dass** auf der Oberseite (12) der Sensorelementeinrichtung (11, 111) bzw. des Lichtleiters (20, 120) eine lichtundurchlässige Abdeckung oder Beschichtung (32) vorgesehen ist, die insbesondere so ausgebildet ist, dass sie mit einem Laser entfernbar ist zum Herausarbeiten von Ausschnitten (34) zur Durchstrahlung mit Licht aus dem Ausstrahlbereich (23) des Lichtleiters (20, 120) für die Leuchtanzeige (36).

11. Bedieneinrichtung nach einem der vorhergehenden Ansprüche, **dadurch gekennzeichnet, dass** genau eine Sensorelementeinrichtung (11, 111) genau einen kapazitiven Berührungsschalter bildet.

12. Elektrogerät mit einer Bedieneinrichtung (40) nach einem der vorhergehenden Ansprüche, **dadurch gekennzeichnet, dass** das Elektrogerät ein Elektrokochfeld (46) ist mit einer Kochfeldplatte (48), wobei ein Teil der Kochfeldplatte (48) die Bedienfläche bildet, wobei die Bedieneinrichtung (40) unter der Kochfeldplatte (48) angeordnet ist und die Bedieneinrichtung (40) eine Vielzahl von Sensorelementeinrichtungen (11, 111) aufweist.

## Claims

1. Operating device (40) with a luminous display (36) and with a capacitive touch switch and a sensor element device (11, 111) for the capacitive touch switch, the sensor element means (11, 111) comprising:
- a sensor element (15, 115) for the capacitive touch switch of the operating device (40),
- a light guide (20, 120) for the illuminated display (36), which is made of light-transmitting material, the light guide (20, 120) having a light input area (22, 122) and a light output area (23),
- a shielding material (26, 126) which surrounds the light guide (20, 120) except for the light-emitting region (22, 122) and the light-emitting region (23), the shielding material (26, 126) being opaque in combination with the light guide (20, 120),
- at least one metallic sensor element (15, 115) consisting of at least one metal part,
wherein:
- the sensor element (11, 111) has a lower side (13) and an upper side (12),
- the sensor element (15, 115) extends from the bottom side (13) of the sensor element means (11, 111) to the top side (12) of the sensor element means (11, 111),
- the sensor element device (11, 111) forms an integrated unit with light guide (20, 120), shielding material (26, 126) and sensor element (15, 115), in particular as an injection-moulded part,
- the sensor element (15, 115) projects up to a plane of the underside (13) of the sensor element device (11, 111) and at least partially defines the plane of the underside (13),
- no part of the sensor element device (11, 111) projects downwards beyond the underside (13) of the sensor element device (11, 111) or beyond the sensor element (15, 115),
- the operating device (40) has an operating surface (48) under which the sensor element device (11, 111) is arranged,
- the capacitive sensor element (15, 115) or one of the sections of the capacitive sensor element (15, 115) is placed with its upper side (16, 116) against an underside (49) of the operating surface (48),
- the operating device (40) has a component carrier (41) on which the sensor element device (11, 111) is arranged and electrically connected,
- the component carrier (41) has on its upper side at least one contact field (42) on which the capacitive sensor element (15, 115) rests and is mechanically and electrically connected.

2. Operating device according to claim 1, **characterised in that** the capacitive sensor element (15, 115) is soldered (44) onto the contact field (42) or is glued with electrically conductive adhesive.

3. Operating device according to one of the preceding claims, **characterised in that** the sensor element (15, 115) is not adjacent to the light guide (20, 120) or runs separately from the light guide (20, 120).

4. Operating device according to one of the preceding claims, **characterized in that** the sensor element (15, 115) extends on one side of the sensor element device (11, 111).

5. Operating device according to one of claims 1 to 3, **characterized in that** the sensor element (15, 115) runs at least on two sides of the sensor element device (11, 111), preferably on adjacent sides or on opposite sides, in particular in the first case a single sensor element (15, 115) being provided, which is bent or angled, and in the second case two separate and separate sensor elements (15, 115) being provided, preferably identical or mirror-image sensor elements (15, 115). and in the second case two separate and distinct sensor elements (15, 115) are provided, preferably identical or mirror-image identical sensor elements (15, 115).

6. Operating device according to one of the preceding claims, **characterised in that** the sensor element device (11, 111) is produced by injection moulding, in particular by multicomponent injection moulding, wherein preferably the at least one sensor element (15, 115) is moulded or injected on or at least partially moulded around.

7. Operating device according to one of the preceding claims, **characterised in that** the sensor element (15, 115) is provided on an outer side, preferably being exposed on the outer side.

8. Operating device according to one of the preceding claims, **characterized in that** the sensor element (15) is bent over in the region of the underside (13) of the sensor element device (11) on the underside (13), in particular with an angular section (17) which preferably rests with one outer side on the sensor element device (11) or on the shielding material (26) and with another outer side runs in the plane of the underside (13) of the sensor element device (11) or forms part of this underside (13) and at least partially defines the plane of the underside (13).

9. Operating device according to one of the preceding claims, **characterised in that** the sensor element (15, 115) is bent over in an upper region, which preferably extends in a surface of the upper side (12) of the sensor element device (11, 111), towards a central region of this upper side (12), and is preferably bent over approximately at right angles, in particular has a spacing from the light guide (20, 120).

10. Operating device according to one of the preceding claims, **characterised in that** a light-impermeable cover or coating (32) is provided on the upper side (12) of the sensor element device (11, 111) or of the light guide (20, 120), which is designed in particular in such a way that it can be removed with a laser for working out cutouts (34) for the transmission of light from the radiation area (23) of the light guide (20, 120) for the luminous display (36).

11. Operating device according to one of the preceding claims, **characterised in that** precisely one sensor element device (11, 111) forms precisely one capacitive touch switch.

12. Electrical appliance with an operating device (40) according to one of the preceding claims, **characterised in that** the electrical appliance is an electric hob (46) with a hob plate (48), wherein a part of the hob plate (48) forms the operating surface, wherein the operating device (40) is arranged under the hob plate (48) and the operating device (40) has a plurality of sensor element devices (11, 111).

## Revendications

1. Dispositif de commande (40) avec un affichage lumineux (36) et avec un commutateur de contact capacitif et un dispositif d'élément de détection (11, 111) pour le commutateur de contact capacitif, le dispositif d'élément de détection (11, 111) comprenant:
- un élément de détection (15, 115) pour le commutateur de contact capacitif du dispositif de commande (40),
- un guide de lumière (20, 120) pour l'affichage lumineux (36), qui est constitué d'un matériau transparent à la lumière, le guide de lumière (20, 120) présentant une zone de rayonnement (22, 122) pour la lumière et une zone de rayonnement (23) pour la lumière,
- un matériau de protection (26, 126) entourant le guide de lumière (20, 120) à l'exception de la zone d'entrée (22, 122) et de la zone de sortie (23), le matériau de protection (26, 126) étant opaque à la lumière en association avec le guide de lumière (20, 120),
- au moins un élément de détection métallique (15, 115) constitué d'au moins une pièce métallique,
dans lequel :
- le dispositif d'élément de détection (11, 111) présente une face inférieure (13) et une face supérieure (12),
- l'élément de détection (15, 115) s'étend de la face inférieure (13) du dispositif d'élément de détection (11, 111) jusqu'à la face supérieure (12) du dispositif d'élément de détection (11, 111),
- le dispositif d'élément de détection (11, 111) forme une unité de construction intégrée avec un guide de lumière (20, 120), un matériau de blindage (26, 126) et un élément de détection (15, 115), en particulier sous forme de pièce moulée par injection,
- l'élément de détection (15, 115) s'étend jusqu'à un plan de la face inférieure (13) du dispositif d'élément de détection (11, 111) et définit au moins partiellement le plan de la face inférieure (13),
- aucune partie du dispositif d'élément de détection (11, 111) ne dépasse vers le bas de la face inférieure (13) du dispositif d'élément de détection (11, 111) ou de l'élément de détection (15, 115),
- le dispositif de commande (40) présente une surface de commande (48) sous laquelle est disposé le dispositif d'élément de détection (11, 111),
- l'élément de détection capacitif (15, 115) ou l'une des sections de l'élément de détection capacitif (15, 115) est appliqué avec sa face supérieure (16, 116) contre une face inférieure (49) de la surface de commande (48),
- le dispositif de commande (40) présente un support de composants (41) sur lequel est disposé le dispositif d'élément de détection (11, 111) et qui est raccordé électriquement,
- le support de composants (41) présente sur sa face supérieure au moins un champ de contact (42) sur lequel l'élément de détection capacitif (15, 115) s'applique et est relié mécaniquement et électriquement.

2. Dispositif de commande selon la revendication 1, **caractérisé en ce que** l'élément de détection (15, 115) est soudé (44) ou est collé à l'aide d'un adhésif conducteur électrique sur le champ de contact (42).

3. Dispositif de commande selon l'une des revendications précédentes, **caractérisé en ce que** l'élément de détection (15, 115) n'est pas adjacent au guide de lumière (20, 120) ou s'étend séparément du guide de lumière (20, 120).

4. Dispositif de commande selon l'une des revendications précédentes, **caractérisé en ce que** l'élément de détection (15, 115) s'étend sur un côté du dispositif d'élément de détection (11, 111).

5. Dispositif de commande selon l'une des revendications 1 à 3, **caractérisé en ce que** l'élément de détection (15, 115) s'étend au moins sur deux côtés du dispositif d'élément de détection (11, 111), de préférence sur des côtés adjacents ou sur des côtés opposés, un seul élément de détection (15, 115) étant prévu, en particulier dans le premier cas, qui est plié ou qui s'oppose, et dans le second cas, il est prévu deux éléments de détection (15, 115) séparés et distincts, de préférence des éléments de détection (15, 115) identiques ou symétriques.

6. Dispositif de commande selon l'une des revendications précédentes, **caractérisé en ce que** le dispositif d'élément de détection (11, 111) est fabriqué par un procédé de moulage par injection, en particulier par un procédé de moulage par injection à plusieurs composants, de préférence au moins un élément de détection (15, 115) étant moulé par injection ou injecté ou au moins partiellement enrobé par injection.

7. Dispositif de commande selon l'une des revendications précédentes, **caractérisé en ce que** l'élément de détection (15, 115) est prévu sur un côté extérieur, de préférence en étant exposé sur le côté extérieur.

8. Dispositif de commande selon l'une des revendications précédentes, **caractérisé en ce que** l'élément de détection (15) est replié dans la zone de la face inférieure (13) du dispositif d'élément de détection (11) contre la face inférieure (13), en particulier avec une section angulaire (17), qui s'appuie de préférence par un côté extérieur sur le dispositif d'élément de détection (11) ou sur le matériau de blindage (26) et qui s'étend par un autre côté extérieur dans le plan du face inférieur (13) du dispositif d'élément de détection (11), respectivement forme une partie de cette face inférieure (13) et définit au moins partiellement le plan de la face inférieure (13).

9. Dispositif de commande selon l'une des revendications précédentes, **caractérisé en ce que** l'élément de détection (15, 115), dans une zone supérieure qui s'étend de préférence dans une surface de la face supérieure (12) du dispositif d'élément de détection (11, 111), est plié vers une zone centrale de cette face supérieure (12), de préférence est plié à peu près à angle droit, en particulier présente un écart par rapport au guide de lumière (20, 120).

10. Dispositif de commande selon l'une des revendications précédentes, **caractérisé en ce que**, sur la face supérieure (12) du dispositif d'élément de détection (11, 111) ou de la lentille optique, un cache ou une protection est prévu, du guide de lumière (20, 120), il est prévu un recouvrement ou un revêtement opaque (32) qui est en particulier conçu de telle sorte qu'il peut être enlevé au moyen d'un laser pour réaliser des découpes (34) pour le rayonnement de la lumière à partir de la zone de rayonnement (23) du guide de lumière (20, 120) pour l'affichage lumineux (36).

11. Dispositif de commande selon l'une des revendications précédentes, **caractérisé en ce qu'**exactement un dispositif d'élément de détection (11, 111) forme exactement un commutateur de détection capacitif.

12. Appareil électrique avec un dispositif de commande (40) selon l'une des revendications précédentes, **caractérisé en ce que** l'appareil électrique est une plaque de cuisson électrique (46) avec une plaque de cuisson (48), une partie de la plaque de cuisson (48) formant la surface de commande, le dispositif de commande (40) étant disposé sous la plaque de cuisson (48) et le dispositif de commande (40) présentant une pluralité de dispositifs d'élément de détection (11, 111).
